(19) Europäisches Patentamt / European Patent Office / Office européen des brevets

(11) **EP 3 665 490 B1**

(12) **FASCICULE DE BREVET EUROPEEN**

(45) Date de publication et mention
de la délivrance du brevet:
**29.05.2024 Bulletin 2024/22**

(21) Numéro de dépôt: **18753143.9**

(22) Date de dépôt: **07.08.2018**

(51) Classification Internationale des Brevets (IPC):
**G01R 31/11** *(2006.01)*

(52) Classification Coopérative des Brevets (CPC):
**G01R 31/11**

(86) Numéro de dépôt international:
**PCT/EP2018/071437**

(87) Numéro de publication internationale:
**WO 2019/030246 (14.02.2019 Gazette 2019/07)**

(54) **PROCÉDÉ, MIS EN OEUVRE PAR ORDINATEUR, DE RECONSTRUCTION DE LA TOPOLOGIE D'UN RÉSEAU DE CABLES, UTILISANT UN ALGORITHME GÉNÉTIQUE**

COMPUTER-IMPLEMENTIERTES VERFAHREN ZUR REKONSTRUKTION DER TOPOLOGIE EINES KABELNETZWERKS UNTER VERWENDUNG EINES GENETISCHEN ALGORITHMUS

COMPUTER-IMPLEMENTED METHOD FOR RECONSTRUCTING THE TOPOLOGY OF A NETWORK OF CABLES, USING A GENETIC ALGORITHM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.08.2017 FR 1757650**

(43) Date de publication de la demande:
**17.06.2020 Bulletin 2020/25**

(73) Titulaire: **Commissariat à l'Énergie Atomique et aux Énergies Alternatives
75015 Paris (FR)**

(72) Inventeurs:
• **BENOIT, Jaume**
  **91120 Palaiseau (FR)**
• **KAFAL, Moussa**
  **91940 Les Ulis (FR)**

(74) Mandataire: **Atout PI Laplace
Immeuble Up On
25 Boulevard Romain Rolland
CS 40072
75685 Paris Cedex 14 (FR)**

(56) Documents cités:
WO-A1-2014/180663    CN-A- 102 982 394
CN-A- 104 134 104    CN-A- 104 240 150
CN-A- 105 552 892    CN-B- 103 036 234
CN-B- 103 633 739    CN-B- 103 701 117
US-A1- 2002 186 760    US-A1- 2006 182 269

• Smail Mostafa Kamel ET AL: "Reconstruction of faulty wiring networks using reflectometry response and genetic algorithms", INTERNATIONAL JOURNAL OF APPLIED ELECTROMAGNETICS AND MECHANICS, vol. 35, no. 1, 17 January 2011 (2011-01-17), pages 39-55, XP055970579, NL ISSN: 1383-5416, DOI: 10.3233/JAE-2011-1320

**Description**

L'invention concerne le domaine de l'analyse technique et la surveillance de réseaux de câbles complexes. Plus précisément, elle porte sur un procédé de reconstruction de la topologie d'un réseau de câbles. L'invention vise à proposer une méthode permettant de déterminer la topologie d'un réseau, c'est-à-dire les points de jonctions entre plusieurs câbles, le nombre de câbles connectés en chaque point ainsi que leurs longueurs respectives mais également les impédances caractéristiques de chaque tronçon de câble ainsi que les impédances des charges en fin de câble. La méthode proposée est basée sur l'exploitation d'un réflectogramme temporel obtenu par une injection d'un signal maitrisé dans le réseau de câbles puis par une mesure du signal réfléchi sur les différentes discontinuités d'impédance du réseau. Ainsi, l'invention concerne plus largement le domaine des méthodes dites de réflectométrie qui vise à fournir des informations sur un câble ou un réseau de câbles à partir d'un réflectogramme.

Les câbles sont omniprésents dans tous les systèmes électriques, pour l'alimentation ou la transmission d'information à l'intérieur de bâtiments ou de véhicules tels que des aéronefs. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention s'applique à tout type de réseaux de câbles, notamment des câbles électriques, en particulier des câbles de transmission d'énergie ou des câbles de communication, dans des installations fixes ou mobiles. Les câbles concernés peuvent être coaxiaux, bifilaires, en lignes parallèles, en paires torsadées ou autre, pourvu qu'il soit possible d'y injecter un signal de réflectométrie en un point du réseau de câble et de mesurer sa réflexion au même point ou en un autre point.

La présente invention a notamment pour objectif de permettre la reconstruction de la topologie de réseaux de câbles complexes dont les plans ne sont pas disponibles où pour lesquels une intervention urgente nécessite la connaissance immédiate de la topologie du réseau. Ce type de problème existe notamment pour des réseaux de câbles électriques ou d'énergie à l'intérieur d'un bâtiment ou à l'intérieur d'un véhicule. Un technicien souhaitant effectuer un dépannage du réseau suite à la détection d'un problème électrique peut avoir besoin d'une connaissance précise de la topologie du réseau pour l'aider dans l'élaboration de son diagnostic. Par ailleurs, certains bâtiments présentent un niveau de confidentialité qui interdit, par nature, la diffusion des plans du réseau électrique.

Un autre problème est spécifique au domaine des méthodes de réflectométrie appliquées à la détection de défauts.

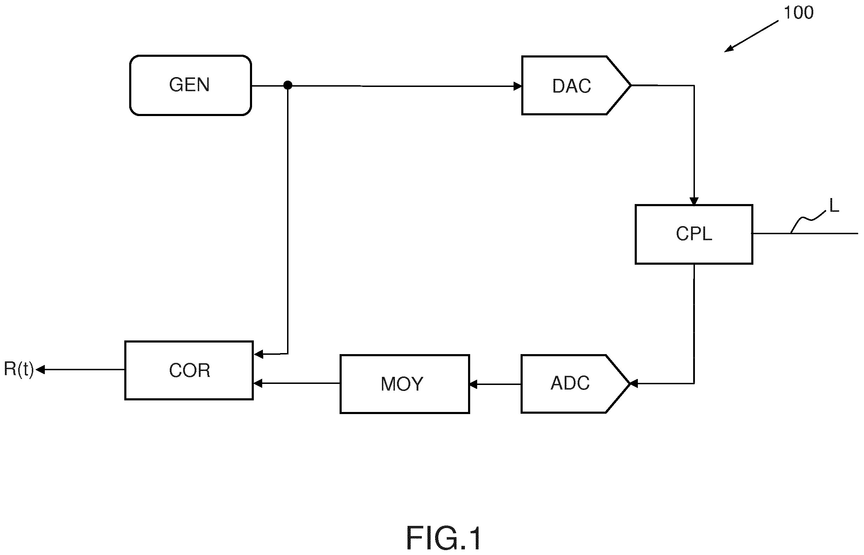

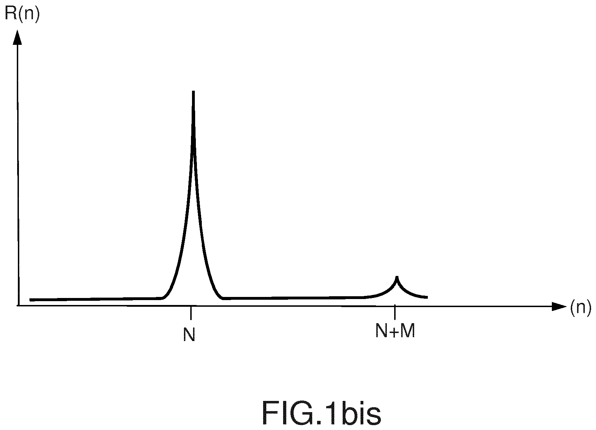

La figure 1 représente un schéma d'un système 100 d'analyse de défaut dans une ligne de transmission L, telle qu'un câble, selon une méthode usuelle de réflectométrie temporelle de l'état de l'art. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur directionnel CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit partiellement sur la discontinuité d'impédance provoquée par le défaut. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Une corrélation COR est ensuite effectuée entre le signal numérique mesuré et une copie du signal numérique généré avant injection afin de produire un réflectogramme temporel R(t) correspondant à l'inter-corrélation entre les deux signaux.

Comme cela est connu dans le domaine des méthodes de diagnostic par réflectométrie temporelle, la position $d_{DF}$ d'un défaut sur le câble L, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut.

La figure 1 bis représente un exemple de réflectogramme R(n) obtenu à l'aide du système de la figure 1, sur lequel on observe un premier pic d'amplitude à une abscisse N et un second pic d'amplitude à une abscisse N+M. Le premier pic d'amplitude correspond à la réflexion du signal au point d'injection dans le câble, tandis que le second pic correspond à la réflexion du signal sur une discontinuité d'impédance provoquée par un défaut

Différentes méthodes connues sont envisageables pour déterminer la position $d_{DF}$. Une première méthode consiste à appliquer la relation liant distance et temps : $d_{DF} = V_g \cdot t_{DF}/2$ où $V_g$ est la vitesse de propagation du signal dans le câble. Une autre méthode possible consiste à appliquer une relation de proportionnalité du type $d_{DF}/ t_{DF} = L_c/t_0$ où $L_c$ est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

Un dispositif d'analyse (non représenté à la figure 1) est chargé d'analyser le réflectogramme R(t) pour en déduire des informations de présence et/ou localisation de défauts ainsi que les caractéristiques électriques éventuelles des défauts. En particulier, l'amplitude d'un pic dans le réflectograme est directement liée au coefficient de réflexion du signal sur la discontinuité d'impédance provoquée par le défaut.

La détection et la localisation de défauts au moyen d'un système de réflectométrie présente un intérêt important car plus tôt un défaut est détecté, plus il est possible d'intervenir pour corriger/réparer le défaut avant que la dégradation ne soit trop importante. Ainsi, la surveillance de l'état de santé d'un câble permet de maintenir un usage fiable du câble pendant toute sa durée de vie.

Dans le cas d'un réseau de câbles complexe comprenant de nombreuses interconnexions, l'analyse d'un réflectogramme en vue de caractériser la présence de défauts est plus difficile à mettre en oeuvre car les jonctions entre les différents câbles du réseau ainsi que les charges en fin de câbles entrainent également des réflexions du signal qui peuvent se superposer à celles résultant d'un défaut. En particulier, des réflexions multiples peuvent exister entre plusieurs jonctions ou plus généralement plusieurs points singuliers du réseau. Les superpositions de réflexions multiples du signal sur différents points singuliers du réseau peuvent s'annuler mutuellement, se renforcer ou se combiner de sorte à créer de nombreux pics parasites dans le réflectogramme. Par ailleurs, le nombre de réflexions du signal tend à augmenter exponentiellement avec le nombre de câbles interconnectés dans le réseau. Ainsi, les réseaux de câbles complexes produisent des réflectogrammes très complexes à analyser.

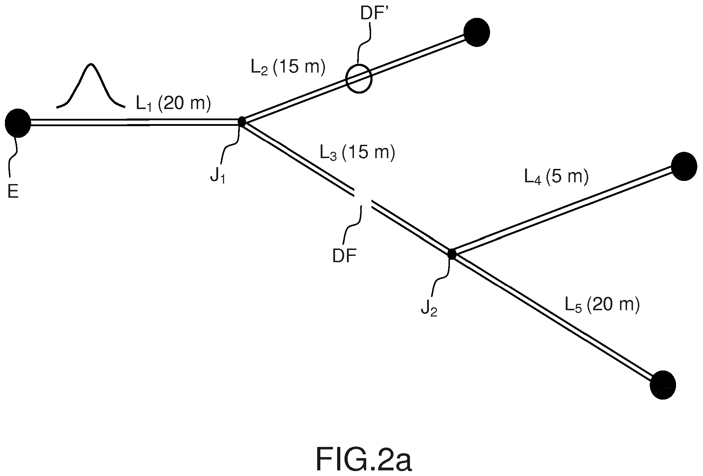

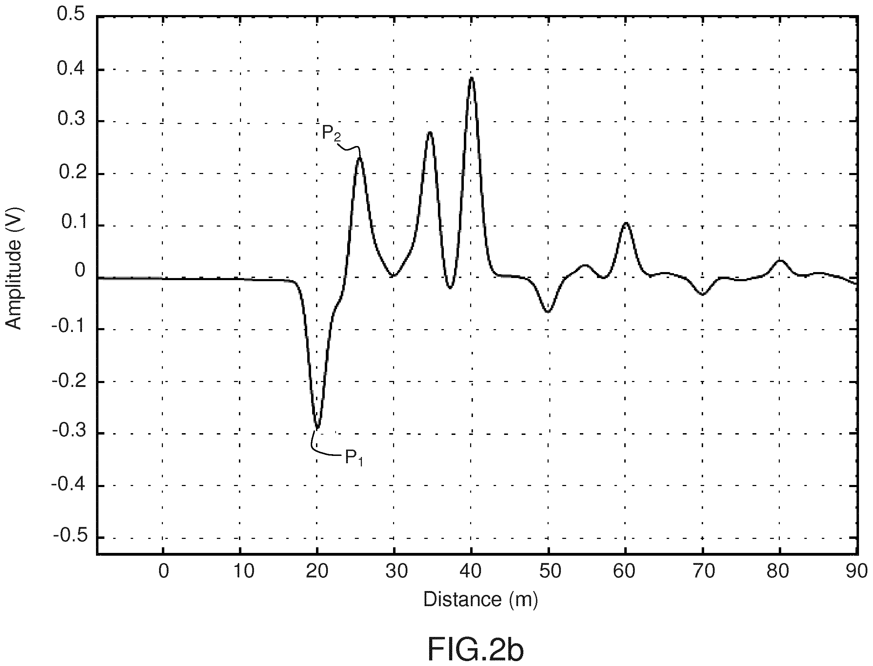

En particulier, même si un pic caractéristique d'un défaut peut être identifié dans un réflectogramme, la localisation du défaut peut être ambiguë car le réflectogramme permet uniquement de connaitre la distance entre le défaut et le point d'injection du signal, mais pas sur quelle branche du réseau est situé le défaut. Pour illustrer ce phénomène, un exemple de réseau de câbles comprenant cinq branches et deux jonctions est représenté sur la figure 2a. Le réflectogramme associé à ce réseau est illustré sur la figure 2b, en considérant l'injection et la mesure du signal au point E du réseau. Sur le réflectogramme, on identifie un premier pic P1 d'amplitude négative qui correspond à la première jonction J1, puis un deuxième pic P2 qui correspond à un défaut DF. La localisation précise de ce défaut DF n'est pas possible car il peut être situé soit sur la branche L2 au point DF', soit sur la branche L3 au point DF. Les autres pics du réflectogramme correspondent à des réflexions directes ou multiples sur les extrémités des différents câbles ainsi que sur la seconde jonction J2.

On voit donc que les méthodes de surveillance de l'état de santé d'un réseau de câbles, par réflectométrie, ne sont pas suffisantes lorsque le réseau de câbles est complexe, c'est-à-dire qu'il présente de nombreuses branches et interconnexions.

Il existe donc un besoin pour une méthode permettant de déterminer la topologie d'un réseau de câbles sans information a priori. La connaissance de la topologie du réseau peut être associée à une méthode de réflectométrie usuelle pour pouvoir mieux exploiter un réflectogramme afin d'identifier et localiser des défauts éventuels. En effet, si on connait les points singuliers du réseau, c'est-à-dire les jonctions entre câbles et les longueurs des différentes branches du réseau, il est possible de faire correspondre certains pics d'un réflectogramme avec ces points singuliers et ainsi discriminer les pics qui correspondent à des éléments physiques du réseau de ceux qui correspondent à des défauts.

La demande de brevet américaine US20060182269 décrit une méthode de reconstruction de la topologie d'un réseau de câbles par exploitation d'un réflectogramme.

La méthode décrite est limitée au cas de réseaux pour lesquels tous les câbles sont terminés par un circuit ouvert ou un court circuit et ont la même impédance caractéristique. Ces hypothèses ne sont pas réalistes car dans un cas réel, des appareils peuvent être connectés à l'extrémité des câbles avec une charge qui n'est pas adaptée au câble. Par ailleurs, tous les câbles composant un réseau n'ont pas forcément la même nature et ne présentent donc pas systématiquement la même impédance caractéristique.

La méthode proposée dans ce document consiste à reconstruire progressivement le réseau de câbles en analysant successivement le signe et la valeur de l'amplitude de chaque pic d'un réflectogramme. Cette méthode présente l'inconvénient d'être fastidieuse à mettre en oeuvre car elle n'est pas aisément automatisable. En effet, elle nécessite une recherche spécifique, pour chaque pic du réflectogramme, des différentes hypothèses de reconstruction possibles du réseau, afin d'avancer pas à pas jusqu'à reconstruire totalement le réseau. Par ailleurs, la méthode proposée dans ce document ne permet pas de converger vers une solution unique mais au contraire produit plusieurs solutions ambigües.

L'article "Reconstruction of faulty wiring networks using reflectometry response and genetic algorithms" de M. K. Smail et al. divulgue un procédé de reconstruction de la topologie d'un réseau de câbles à l'aide d'un algorithme génétique.

L'invention propose une méthode de reconstruction de la topologie d'un réseau de câbles qui est automatisée par le biais de l'utilisation d'un algorithme d'optimisation qui est un algorithme génétique. La méthode présente l'avantage de converger vers une solution ou un nombre réduit de solutions dans un temps limité.

L'invention a pour objet un procédé itératif, mis en oeuvre par ordinateur, de reconstruction de la topologie d'un réseau de câbles comprenant les étapes de :

- Obtenir un réflectogramme temporel mesuré $R_m$ à partir d'un signal préalablement injecté dans le réseau de câbles,
- Simuler initialement une pluralité d'hypothèses de réseaux de câbles, puis exécuter itérativement les étapes suivantes :
- Obtenir, pour chaque hypothèse de réseau de câbles simulé, un réflectogramme temporel simulé associé $R_{i,j}$,
- Evaluer, pour chaque hypothèse de réseau de câbles simulé, un critère d'erreur $E(R_{i,j}-R_m)$ entre le réflectogramme temporel mesuré $R_m$ et le réflectogramme temporel simulé $R_{i,j}$,
- Appliquer auxdits réseaux de câbles simulés un algorithme d'optimisation ayant pour fonction de produire une pluralité de réseaux de câbles modifiés présentant globalement un critère d'erreur $E(R_{i,j}-R_m)$ diminué,
- Remplacer lesdits réseaux de câbles simulés de l'itération précédente par lesdits réseaux de câbles modifiés pour l'itération suivante.

Selon l'invention, l'algorithme d'optimisation est un algorithme génétique.

Selon un mode de réalisation particulier de l'invention, l'algorithme d'optimisation génétique comprend au moins une opération de mutation d'un réseau de câbles simulé pour obtenir un réseau de câbles modifié.

Selon un mode de réalisation particulier de l'invention, l'algorithme d'optimisation génétique comprend au moins une opération de croisement de deux réseaux de câbles simulés pour obtenir un réseau de câble modifié, un croisement étant appliqué sur les paramètres structurels et les paramètres numériques de topologie d'un réseau de câble.

Selon un mode de réalisation particulier de l'invention, les P réseaux de câbles simulés qui présentent les critères d'erreur les plus faibles ne sont pas modifiés par l'algorithme d'optimisation génétique, P étant un nombre entier prédéterminé au moins égal à un.

Selon un mode de réalisation particulier de l'invention, l'algorithme d'optimisation génétique comprend au moins une opération de croisement de deux réseaux de câbles simulés pour obtenir un réseau de câbles modifié, un croisement étant appliqué uniquement sur les paramètres numériques de topologie d'un réseau de câble.

Selon l'invention, la pluralité d'hypothèses de réseaux de câbles simulés couvre tous les paramètres structurels possibles de topologie de réseaux de câbles, les paramètres structurels comprenant au moins le nombre de jonctions et le nombre de branches reliées à chaque jonction.

Selon une variante, le procédé selon l'invention comprend en outre une étape de supprimer, avant d'appliquer l'algorithme d'optimisation, les M réseaux de câbles simulés qui présentent les critères d'erreur les plus élevés, M étant un nombre entier prédéterminé au moins égal à un.

Selon une variante, le procédé selon l'invention comprend un test d'arrêt comprenant une étape de comparer les critères d'erreur des réseaux de câbles simulés restants à un second seuil prédéterminé et si au moins un réseau de câble simulé présente un critère d'erreur inférieur audit second seuil arrêter le procédé.

Selon un aspect particulier de l'invention, le critère d'erreur est une distance euclidienne.

Selon une variante, le procédé selon l'invention comprend une étape d'affichage de la topologie reconstruite du réseau de câbles sur un dispositif d'affichage.

Selon une variante, le procédé selon l'invention comprend une étape préalable d'injection du signal dans le réseau de câbles.

L'invention a également pour objet un programme d'ordinateur comportant des instructions pour l'exécution du procédé de reconstruction de la topologie d'un réseau de câbles selon l'invention, lorsque le programme est exécuté par un processeur.

L'invention a également pour objet un support d'enregistrement lisible par un processeur sur lequel est enregistré un programme comportant des instructions pour l'exécution du procédé de reconstruction de la topologie d'un réseau de câbles selon l'invention, lorsque le programme est exécuté par un processeur.

D'autres caractéristiques et avantages de la présente invention apparaîtront mieux à la lecture de la description qui suit en relation aux dessins annexés qui représentent :

- La figure 1, un schéma d'un système de réflectométrie selon l'art antérieur,

**EP 3 665 490 B1**

- La figure 1bis, un exemple de réflectogramme obtenu avec le système de réflectométrie de la figure 1 pour un câble simple,
- La figure 2a, un exemple de réseau de câbles comprenant plusieurs branches et jonctions,
- La figure 2b, un exemple de réflectogramme temporel obtenu pour le réseau de câbles de la figure 2a,
- La figure 3, un organigramme détaillant les étapes de mise en oeuvre d'un procédé de reconstruction de topologie d'un réseau de câbles, selon un premier mode de réalisation de l'invention,
- Les figures 4a et 4b, une illustration d'un croisement de deux réseaux ayant des topologies basées sur des graphes identiques mais des valeurs numériques d'impédances caractéristiques différentes,
- La figure 5, un organigramme détaillant les étapes de mise en oeuvre d'un procédé de reconstruction de topologie d'un réseau de câbles, selon un troisième mode de réalisation de l'invention,
- Les figures 6a, 6b et 6c, trois illustrations d'une opération de croisement de deux réseaux de topologies différentes,

Un objectif du procédé selon l'invention est de fournir une reconstruction de la topologie d'un réseau totalement ou partiellement inconnu. Les informations fournies par le procédé comprennent le nombre de jonctions ou points de connexions du réseau, le nombre de branches ou sections de câbles connectées en chaque jonction, la longueur de chaque branche ainsi que l'impédance caractéristique de chaque branche et la valeur de l'impédance de la charge en fin de branche, c'est-à-dire à l'extrémité d'un câble qui n'est pas relié à un autre câble. Le procédé selon l'invention peut fournir toutes ces informations afin de produire une reconstruction complète de la topologie d'un réseau ou fournir une partie seulement de ces informations. Le nombre et le type d'informations caractérisant la topologie d'un réseau est un paramètre de l'invention qui est spécifié par un utilisateur.

L'invention est applicable à tout type de réseaux de câbles ayant une topologie en arbre et ne s'applique pas aux réseaux ayant une topologie en forme de boucle.

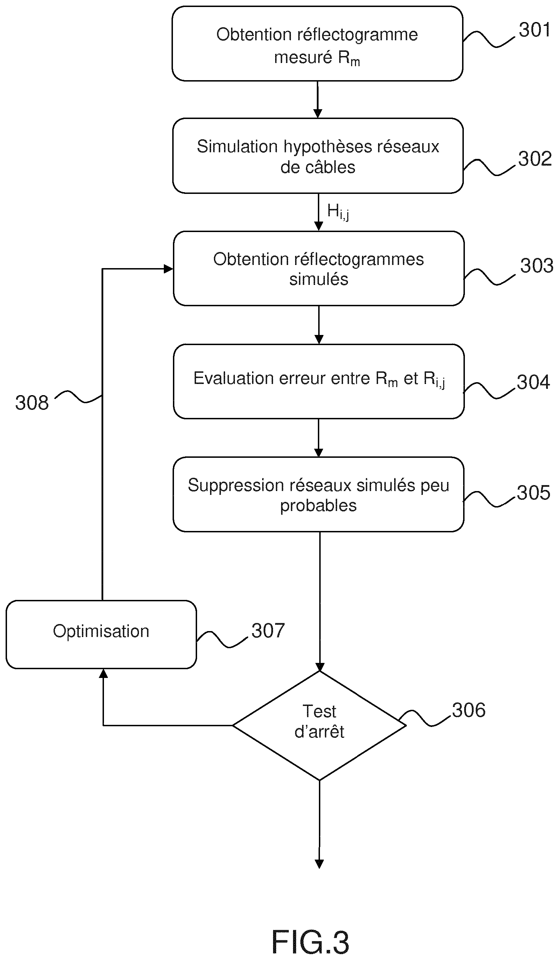

La figure 3 schématise, sur un organigramme, les étapes de mise en oeuvre du procédé selon un premier mode de réalisation de l'invention.

Dans une première étape 301 du procédé, un réflectogramme temporel $R_m$ est obtenu à partir d'une mesure de réflectométrie. Comme indiqué en préambule, une mesure de réflectométrie est obtenue en injectant un signal maitrisé en un point du réseau de câbles puis en mesurant, au même point ou en un point différent du réseau, le signal qui est rétro-propagé après avoir subi de multiples réflexions sur les discontinuités d'impédance apparaissant dans les câbles du réseau. La mesure de réflectométrie peut être obtenue au moyen du dispositif décrit à la figure 1 ou tout autre équipement équivalent permettant de réaliser la même fonction. Le signal utilisé peut être de nature diverse, il peut s'agir d'un simple signal Gaussien, d'un créneau temporel ou d'une impulsion ou bien d'un signal plus complexe. En fonction de la nature exacte du signal, le réflectogramme temporel $R_m$ est obtenu directement par la mesure du signal rétro-propagé ou bien par un calcul d'inter-corrélation entre cette mesure et une copie du signal injecté dans le réseau. De façon générale, toute mesure de signal comprenant l'information relative aux réflexions du signal sur les points singuliers du réseau, c'est-à-dire les jonctions et les charges en fin de câbles, est compatible de l'invention. Il convient de noter que la mesure du réflectogramme temporel $R_m$ ne nécessite l'accès qu'à un seul port de test du réseau.

Dans une deuxième étape 302 du procédé, on simule plusieurs hypothèses de topologie de réseaux de câbles possibles en tenant compte de contraintes globales sur le réseau à reconstruire, par exemple les nombres maximum et minimum de branches et de jonctions que peut comporter le réseau mais aussi des bornes sur les valeurs numériques des impédances et des longueurs des branches.

Les paramètres de reconstruction d'un réseau sont de deux natures. D'une part on retrouve les paramètres structurels de la topologie d'un réseau que sont le nombre de jonctions et le nombre de branches connectées à chaque jonction. D'autre part, on a également les paramètres numériques de la topologie que sont les longueurs des branches, les valeurs des impédances caractéristiques des branches et les valeurs des impédances des charges en fin de chaque extrémité du réseau.

L'ensemble des hypothèses de réseaux simulés doit parcourir tous les paramètres structurels de topologie possibles et doit comprendre plusieurs hypothèses de paramètres numériques pour chaque hypothèse structurelle.

Une possibilité exhaustive consiste à simuler toutes les valeurs de paramètres numériques et tous les paramètres structurels afin de simuler toutes les hypothèses possibles.

Par la suite, on note $H_{i,j}$ une hypothèse de réseau simulé, avec i un indice indexant une hypothèse de paramètres structurels et j un indice indexant une hypothèse de paramètres numériques. L'indice i varie de 1 à $N_{st}$ où $N_{st}$ est le nombre d'hypothèses possibles de paramètres structurels. L'indice j varie dans un sous-ensemble de l'ensemble des hypothèses possibles de paramètres numériques, ce sous-ensemble étant au plus égal à l'ensemble total des hypothèses de paramètres numériques.

Ensuite, pour chaque hypothèse de topologie simulée, on détermine 303 un réflectogramme temporel simulé associé à cette topologie. Pour cela, on considère le même signal que celui utilisé pour obtenir le réflectogramme mesuré $R_m$ et les mêmes conditions d'injection du signal et de mesure du signal rétro-propagé. Le signal rétro-propagé est simulé, par exemple, en appliquant un modèle numérique de la propagation du signal à travers les câbles du réseau simulé. En particulier, ce modèle prend en compte les coefficients de réflexion et les coefficients de transmission sur chaque jonction ou chaque charge que comprend le réseau simulé. L'Homme du métier peut utiliser ses connaissances générales sur la propagation des ondes pour déterminer un réflectogramme simulé, notamment en se basant sur les équations du télégraphiste qui permettent de décrire l'évolution de la tension et du courant sur une ligne électrique en fonction de la distance et du temps.

$$\frac{\partial v(x,t)}{\partial x} = -Ri(x,t) - L\frac{\partial i(x,t)}{\partial t} \qquad (1)$$

$$\frac{\partial i(x,t)}{\partial x} = -Gv(x,t) - C\frac{\partial v(x,t)}{\partial t} \qquad (2)$$

Les paramètres R,L,C,G correspondent respectivement à la résistance, à l'inductance, à la capacitance et à la conductance de la ligne.

A l'issue de l'étape 303, on obtient plusieurs réflectogrammes simulés $R_{i,j}$ correspondant aux hypothèses $H_{i,j}$

A l'étape suivante 304, on calcule, pour chaque hypothèse de topologie simulée, un critère d'erreur entre le réflectogramme mesuré $R_m$ obtenu à l'étape 301 et le réflectogramme $R_{i,j}$ du réseau simulé. Le critère d'erreur traduit la proximité ou la ressemblance entre les deux réflectogrammes. Il peut consister en une simple différence point à point entre les deux réflectogrammes ou en un calcul de distance plus élaboré. Par exemple, le critère d'erreur peut être égal à la norme euclidienne ou norme 2 de la différence entre les deux réflectogrammes. La norme euclidienne est égale à la racine carrée de la somme des carrés des valeurs de différence point à point entre les deux réflectogrammes. Toute autre distance ou norme peut être envisagée. Le calcul d'erreur peut aussi inclure des pondérations afin de privilégier certaines valeurs temporelles par rapport à d'autre.

A l'étape 305, on supprime les hypothèses de paramètres structurels qui présentent un critère d'erreur élevé. Autrement dit, on sélectionne au moins un indice $i_0$ parmi les indices indexant les hypothèses de paramètres structurels et on supprime toutes les hypothèses $H_{i0,j}$.

Pour cela, on compare chaque critère d'erreur calculé à l'étape 303 à un premier seuil d'erreur dont la valeur est un paramètre fixé de sorte à éliminer les erreurs importantes qui traduisent une trop forte différence entre le réflectogramme mesuré et le réflectogramme simulé. Une autre possibilité est de fixer un pourcentage ou un nombre d'hypothèses de réseaux simulés à supprimer. Par exemple, une seule hypothèse de paramètres structurels (la moins vraisemblable) est éliminée à chaque itération. Si plusieurs hypothèses numériques (indice j) sont disponibles pour chaque hypothèse structurelle (indice i), un critère d'erreur représentatif peut être affecté à l'ensemble des hypothèses numériques pour une hypothèse structurelle, par exemple en effectuant une moyenne.

Dans une autre variante de réalisation, on supprime la ou les hypothèses présentant le ou les critères d'erreur les plus élevés indépendamment des indices i,j.

L'étape 305 permet d'éliminer les topologies dont les paramètres structurels sont peu probables.

A la première itération du procédé, on applique ensuite un algorithme d'optimisation génétique 307 aux réseaux simulés restant après l'étape 305. L'algorithme génétique est appliqué en parallèle à chaque groupe d'hypothèses $H_{i,j}$ ayant les mêmes paramètres structurels mais des paramètres numériques différents.

L'algorithme génétique modifie les réseaux simulés et les réseaux simulés modifiés sont utilisés comme point de départ d'une itération suivante du procédé. Autrement dit, à chaque nouvelle itération, on remplace 308 les réseaux simulés utilisés en entrée de l'étape 304 à l'itération précédente par les réseaux simulés modifiés par l'algorithme génétique 307. Dans ce premier mode de réalisation de l'invention, les modifications apportées aux réseaux simulés concernent uniquement les paramètres numériques des topologies de réseau, c'est-à-dire les longueurs de branches, les valeurs d'impédances caractéristiques des branches et les valeurs des impédances des charges en fin de câble.

Un exemple d'algorithme génétique est décrit dans la référence [1]. Il s'agit d'un algorithme d'optimisation de type métaheuristique. Il consiste, à chaque itération du procédé, à modifier une partie des réseaux simulés par croisement et, optionnellement, par mutation. Selon la terminologie employée pour les algorithmes génétiques, un croisement et une mutation s'appliquent à des individus. Un individu correspond à un réseau simulé qui est représenté, dans ce premier mode de réalisation, par un vecteur modèle qui comprend les différents paramètres numériques d'une topologie, c'est-à-dire les longueurs des différentes branches du réseau, les valeurs des impédances caractéristiques des différentes branches du réseau ainsi que les valeurs des impédances des charges en fin de chaque extrémité libre d'une branche. Un croisement est appliqué à deux individus parents pour produire un individu enfant. L'individu enfant est un réseau simulé modifié qui est obtenu en effectuant une combinaison entre les deux individus parents. La combinaison est, par exemple, une combinaison linéaire pondérée en fonction de poids respectifs attribués aux deux individus parents. L'opération de combinaison linéaire est appliquée à au moins un des paramètres numériques de la topologie d'un réseau simulé. Le poids associé à un individu est directement lié à l'erreur calculée à l'étape 304. Ainsi, un individu présentant un critère d'erreur faible se verra affecter un poids plus élevé qu'un individu présentant un critère d'erreur élevé. En sortie de l'étape 307, le nombre d'individus modifiés est identique au nombre d'individus en entrée de l'étape 307. Les individus modifiés par croisement sont chacun obtenus à partir du croisement de deux individus parents. Les individus parents auxquels est appliqué un croisement sont, par exemple, tirés aléatoirement parmi les individus présents en entrée de l'étape 307. Le tirage aléatoire peut être uniforme ou il peut être non uniforme. Dans ce second cas, les individus présentant un poids élevé ont une probabilité plus élevée d'être sélectionnés pour une opération de croisement. Par ailleurs, lorsque deux individus sont sélectionnés pour être croisés, leurs poids respectifs peuvent aussi être utilisés pour pondérer le croisement des valeurs de leurs vecteurs modèles respectifs.

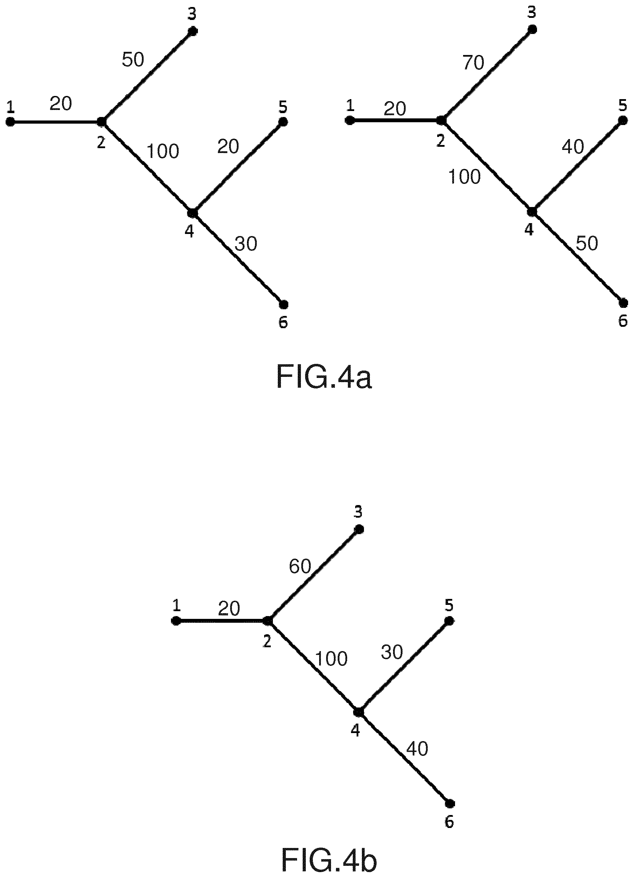

Les figures 4a et 4b illustrent un exemple de croisement de deux réseaux parents ayant des paramètres structurels de topologie identique mais des paramètres numériques de topologie différents.

La figure 4a représente deux réseaux ayant la même structure (même nombre de branches et de jonctions) mais des valeurs d'impédance caractéristique différentes pour certaines branches (représentées par des chiffres sur chaque branche).

La figure 4b représente un réseau obtenu par croisement des deux réseaux de la figure 4a. Les impédances caractéristiques des branches du réseau de la figure 4b sont égales aux moyennes des impédances caractéristiques des branches respectives des réseaux parents de la figure 4a. Dans cet exemple, les deux réseaux parents ont des poids identiques.

Selon une variante de réalisation, une opération de mutation est appliquée à un faible pourcentage des individus modifiés par croisement. Le pourcentage choisi est typiquement inférieur à 1%. Une mutation consiste à modifier aléatoirement la valeur d'un paramètre numérique du vecteur modèle d'un individu, dans les limites des bornes de valeurs imposées par les hypothèses prises pour le réseau recherché.

Les réseaux modifiés obtenus en sortie de l'algorithme génétique 307 viennent remplacer 308 à la prochaine itération, les réseaux simulés de l'itération précédente et le procédé reboucle à l'étape 304.

L'étape d'optimisation 307 permet de faire évoluer les paramètres numériques des hypothèses de topologie vers les paramètres les plus vraisemblables.

A partir de la seconde itération du procédé, un test d'arrêt du procédé 306 est mis en oeuvre après l'étape 305. Si au moins un réseau simulé présente un critère d'erreur inférieur à un second seuil prédéterminé, alors ce réseau simulé est retenu comme étant le plus probable. Si plusieurs réseaux simulés satisfont le test d'arrêt 306, le procédé fournit plusieurs solutions. Ces solutions peuvent être ensuite discriminées en utilisant une connaissance partielle du réseau réel. Le second seuil du test d'arrêt 306 est un paramètre de l'invention. Il peut être fixé en estimant le niveau de proximité entre deux réflectogrammes à partir duquel on peut considérer que les deux réseaux associés à ces deux réflectogrammes sont identiques. Le second seuil peut notamment être fixé par simulation. Alternativement, le test d'arrêt peut également consister à arrêter le procédé au bout d'une certaine durée et à retenir les réseaux simulés restants à l'issue de l'étape 305 ou à retenir uniquement le réseau simulé présentant le critère d'erreur le plus faible.

Le procédé selon le premier mode de réalisation de l'invention permet de reconstruire complètement la topologie d'un réseau inconnu, c'est-à-dire à la fois les paramètres structurels et les paramètres numériques. Dans une variante non revendiquée, une partie seulement des paramètres numériques peuvent être recherchés, par exemple uniquement les longueurs des branches, afin de simplifier la mise en oeuvre du procédé. De ce fait, les paramètres de reconstruction sont configurables.

Le ou les réseaux simulés retenus à l'issue du procédé peuvent être affichés sur un écran ou toute autre interface équivalente pour être visualisés par un utilisateur.

On décrit à présent un exemple non revendiqué dans lequel l'algorithme d'optimisation génétique est remplacé par un algorithme d'optimisation basé sur un algorithme de Newton tel que décrit dans [2]. L'algorithme ou la méthode de Newton est une méthode d'optimisation permettant de trouver numériquement une approximation précise d'un zéro (ou racine) d'une fonction réelle d'une variable réelle. Le principe de cette méthode est le suivant.

Soit F une fonction dérivable, l'objectif de la méthode de Newton est de résoudre l'équation F(x)=0. En partant d'une valeur initiale $x_0$, il est possible de construire une approximation linéaire de la fonction F(x) au voisinage de $x_0$ : $F(x_0+h) = F(x_0) + F'(x_0).h$ avec F'() la dérivée de F(). Le problème revient alors à résoudre l'équation $F(x_0)+ F'(x_0).h=0$.

A partir de ces constatations, on peut dériver une méthode par récurrence décrite par l'équation (3) :

$$x_{k+1}= x_k - F'(x_k)^{-1}. F(x_k) \qquad (3)$$

On applique ce résultat pour mettre en oeuvre l'étape d'optimisation 307 du procédé selon le deuxième mode de réalisation de l'invention. Les autres étapes sont identiques à celles déjà décrites à la figure 3.

L'algorithme d'optimisation basé sur la méthode de Newton est appliqué indépendamment à chaque hypothèse $H_{i,j}$.

L'équation (3) est appliquée à la fonction $F_{i,j}(x) = E(R_{i,j}(x) - R_m)$, où $E()$ est le critère d'erreur utilisé à l'étape 304, par exemple la norme euclidienne, et x est un vecteur contenant l'ensemble des paramètres numériques de topologie pour une hypothèse $H_{i,j}$, qui comprennent les longueurs des branches d'un réseau et/ou les impédances caractéristiques des branches et/ou les impédances des charges aux extrémités du réseau. Ce faisant, on résout l'équation $F_{i,j}(x)=0$ ce qui permet de déterminer les paramètres du vecteur x qui minimisent l'erreur entre le réflectogramme simulé et le réflectogramme mesuré.

On calcule ensuite numériquement la dérivée $F'(x)$ au point x puis on en déduit la valeur du vecteur x à l'itération suivante à partir de l'équation (3).

A partir des nouvelles valeurs des paramètres numériques, on en détermine ensuite les nouveaux réflectogrammes associés à l'itération suivante en rebouclant à l'étape 303.

On décrit à présent un troisième mode de réalisation de l'invention qui est à nouveau basé sur un algorithme d'optimisation génétique.

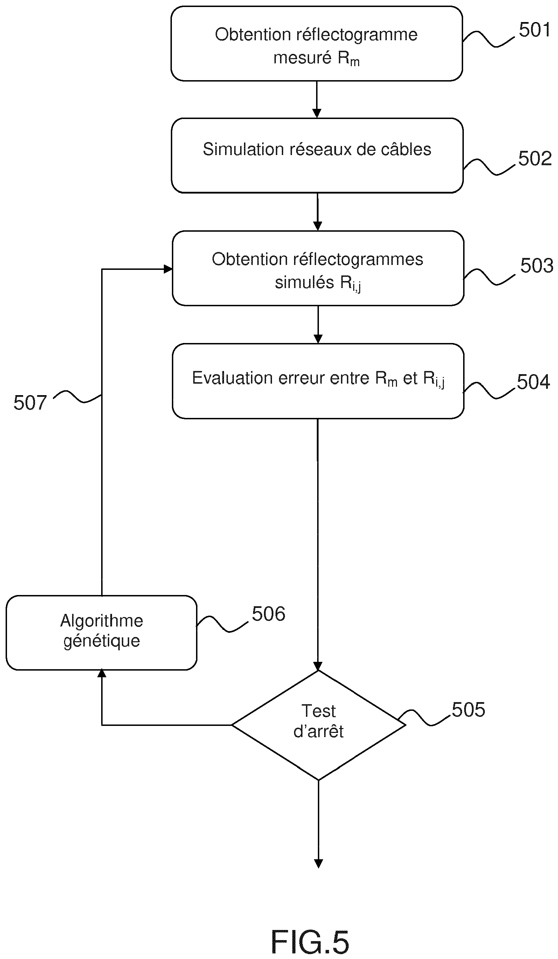

La figure 5 schématise, sur un organigramme, les étapes de mise en oeuvre du procédé selon un troisième mode de réalisation de l'invention.

La première étape 501 du troisième mode de réalisation est identique à la première étape 301 du premier mode de réalisation. Elle consiste à obtenir un réflectogramme mesuré $R_m$ en un point d'un réseau de câbles dont on souhaite déterminer la topologie.

La deuxième étape 502 du troisième mode de réalisation est comparable à la deuxième étape 302 du premier mode de réalisation à une différence près. prêt. Le nombre d'hypothèses de réseaux simulées à l'étape 502 est sensiblement réduit par rapport au nombre d'hypothèses de réseaux simulées à l'étape 302. Il n'est plus nécessaire que l'ensemble des hypothèses de réseaux simulés parcourt tous les paramètres structurels de topologie possibles. A l'inverse, il suffit de simuler un échantillon en nombre limité d'hypothèses de réseaux ayant des paramètres structurels de topologie différents et des paramètres numériques de topologie différents.

Cette étape procure l'avantage de limiter le nombre d'opérations et de place mémoire nécessaires pour simuler les hypothèses de réseaux de câbles. L'ensemble d'hypothèses est choisi pour être représentatif de l'ensemble des réseaux possibles.

La troisième étape 503 du troisième mode de réalisation est identique à la troisième étape 303 du premier mode de réalisation. Elle consiste à déterminer un réflectogramme temporel simulé pour chaque hypothèse de topologie simulée à l'étape 502. Le nombre d'opérations et de place mémoire nécessaires pour réaliser l'étape 503 est également diminué par rapport à la première variante de réalisation du procédé.

La quatrième étape 504 du troisième mode de réalisation est identique à la troisième étape 304 du premier mode de réalisation. Elle consiste à calculer, pour chaque hypothèse de topologie simulée, un critère d'erreur entre le réflectogramme mesuré $R_m$ obtenu à l'étape 301 et le réflectogramme $R_{i,j}$ du réseau simulé.

L'étape 305 du premier mode de réalisation est supprimée dans le troisième mode de réalisation.

Le test d'arrêt 505 mis en place pour le troisième mode de réalisation est identique au test d'arrêt 306 utilisé pour le premier mode de réalisation.

Le procédé selon le troisième mode de réalisation comprend l'application 506 d'un algorithme d'optimisation génétique. Cependant la mise en oeuvre de cet algorithme diffère quelque peu entre le premier mode de réalisation et le troisième mode de réalisation de l'invention.

Dans cette troisième variante, à chaque itération du procédé, on conserve un certain pourcentage ou nombre de réseaux simulés qui ne sont pas modifiés par l'algorithme génétique. Les réseaux simulés non modifiés sont ceux qui présentent un critère d'erreur le plus faible parmi l'ensemble des réseaux simulés disponibles en entrée de l'étape 506. Le pourcentage de réseaux simulés non modifiés est, par exemple, compris entre 5% et 10%.

Ensuite, le restant des réseaux simulés, c'est-à-dire ceux qui ne sont pas maintenus à l'identique, sont modifiés par croisement. Si on note N le nombre de réseaux simulés en entrée de l'algorithme génétique, le nombre de réseaux modifiés en sortie est toujours égal à N. Autrement dit, la taille de la population d'hypothèses de réseaux n'est pas modifiée par l'algorithme génétique. Pour obtenir un réseau modifié en sortie de l'algorithme génétique, on sélectionne deux réseaux simulés en entrée de l'algorithme génétique qui sont désignés réseaux parents. Les deux réseaux parents sont croisés pour obtenir un réseau enfant. Les réseaux parents sont tirés au sort aléatoirement parmi l'ensemble des réseaux simulés en entrée de l'algorithme génétique. Dans une variante particulière de l'invention, le tirage aléatoire est non uniforme. Chaque réseau simulé est affecté d'un poids inversement proportionnel à son critère d'erreur. Ainsi, un réseau simulé ayant un critère d'erreur faible aura une probabilité plus élevée d'être sélectionné comme réseau parent qu'un réseau simulé ayant un critère d'erreur élevé. De cette façon, les réseaux simulés ayant une faible ressemblance avec le réseau réel seront progressivement supprimés au cours des itérations du procédé.

Lorsque deux réseaux simulés sont sélectionnés comme réseaux parents candidats à un croisement, on leur applique une fonction ou opération de croisement pour obtenir un réseau enfant modifié. Cette opération est répétée jusqu'à obtenir un nombre de réseaux enfants modifiés identique au nombre de réseaux simulés en entrée de l'algorithme génétique, en excluant les réseaux simulés qui sont conservés à l'identique d'une itération à l'autre.

Comme expliqué pour l'étape 307 du premier mode de réalisation de l'invention, l'opération de croisement peut être appliquée à des valeurs numériques en effectuant une combinaison linéaire entre ces valeurs. Pour l'étape 506 du troisième mode de réalisation, l'opération de croisement est aussi appliquée aux noeuds ou jonctions des réseaux ainsi qu'aux branches connectées à ces jonctions. Les branches d'un réseau peuvent être identifiées par les noeuds à leurs extrémités. Un réseau enfant est constitué d'une partie des branches d'un premier réseau parent et d'une partie des branches d'un second réseau parent. Ici aussi, le poids affecté à un réseau parent peut être pris en compte pour l'opération de croisement. Ainsi, si le premier réseau parent a un poids supérieur au poids du second réseau parent, le premier réseau parent a une probabilité plus élevée de transmettre ses branches au réseau enfant que le second réseau parent. Pour construire un réseau enfant, on effectue un tirage aléatoire, éventuellement pondéré par les poids respectifs des deux réseaux parents, dans l'ensemble des branches des deux réseaux parents. Le réseau enfant est construit par la concaténation des branches des deux réseaux parents qui sont sélectionnées par ce tirage aléatoire. Si le réseau enfant ne respecte pas les contraintes globales du réseau recherché, alors il est supprimé et l'opération de croisement est renouvelée. Un réseau enfant peut être supprimé notamment si le nombre de branches obtenu est supérieur à un nombre maximum de branches possible ou si le nombre de jonctions obtenu est supérieur à un nombre maximum de jonctions possible ou encore si le réseau obtenu n'est pas continu, c'est-à-dire qu'il est constitué d'au moins deux sous-graphes non connectés entre eux.

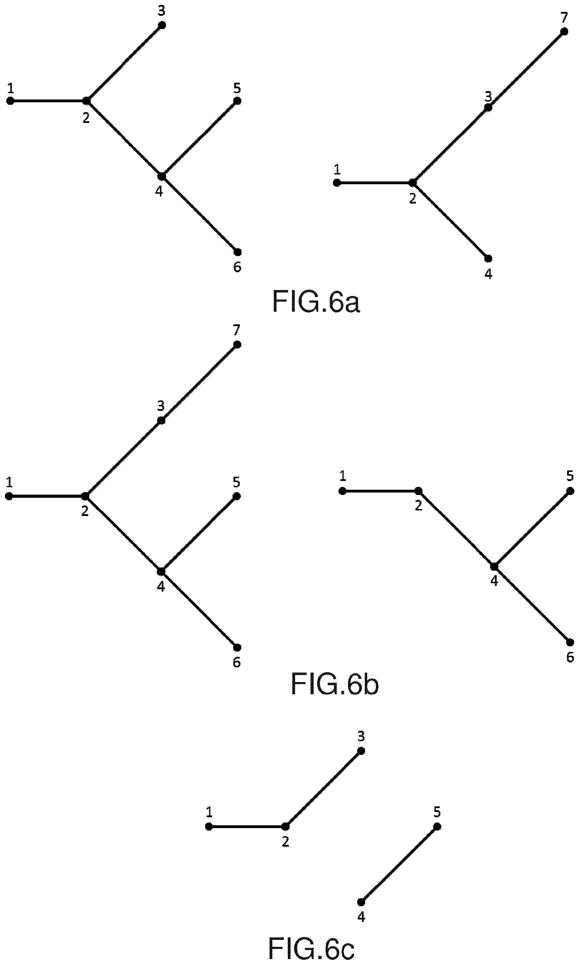

Les figures 6a et 6b illustrent deux exemples de croisement de deux réseaux parents.

La figure 6a représente deux réseaux parents de topologies différentes. Le premier réseau, représenté sur la gauche de la figure 5a, comporte cinq branches qui peuvent être identifiées par les numéros de leurs extrémités respectives : 1-2, 2-3, 2-4, 4-5 et 4-6. Le second réseau, représenté sur la droite de la figure 5a, comporte quatre branches : 1-2, 2-3, 2-4 et 3-7. Les noeuds identiques entre les deux réseaux sont numérotés de la même façon. De façon générale, tous les réseaux simulés comprennent toujours une première branche 1-2 dont la première extrémité 1 correspond au point d'injection et de mesure du signal de réflectométrie.

Sur la figure 6b, on a représenté deux exemples de réseaux enfants obtenus chacun par un croisement différent des deux réseaux parents de la figure 6a. Le réseau enfant représenté sur la gauche de la figure 6b a hérité de l'intégralité des branches des deux réseaux parents. Le réseau enfant représenté sur la droite de la figure 6b a hérité d'une partie seulement des branches de chacun des deux réseaux parents. De façon générale, chacun des deux réseaux enfant est obtenu par un tirage aléatoire parmi l'ensemble des branches des deux réseaux parents. Les poids affectés aux deux réseaux parents peuvent être pris en compte dans le tirage aléatoire afin de favoriser la sélection des branches du réseau parent le plus proche du réseau réel.

Les exemples ci-dessus sont donnés à titre illustratif et nullement limitatif.

Sur la figure 6c, on a représenté un réseau enfant possible obtenu par croisement des deux réseaux parents de la figure 6a. Ce réseau enfant comprend deux sous graphes non-connectés entre eux, respectivement le sous-graphe 1-2, 2-3 et le sous-graphe 4-5. Ce réseau n'étant pas acceptable, il est supprimé et l'opération de croisement est renouvelée jusqu'à obtenir un réseau acceptable.

L'opération de croisement est réalisée sur au moins un paramètre définissant un réseau simulé parmi les branches, les longueurs de branches, les impédances caractéristiques des branches et les impédances des charges à l'extrémité des branches. Par exemple, lorsque deux réseaux parents sont sélectionnés pour être croisés, l'opération de croisement peut être faite sur un ou plusieurs ou tous les paramètres structurels et/ou les paramètres numériques de la topologie. Dans un autre exemple, des réseaux parents différents peuvent être sélectionnés pour réaliser respectivement un croisement sur la base de paramètres structurels et un croisement sur la base de paramètres numériques.

Lorsque tous les réseaux enfants sont obtenus, l'étape 506 peut comprendre en outre une sous-étape de mutation d'un pourcentage faible, typiquement inférieur à 1%, des réseaux modifiés obtenus par croisement. Pour appliquer une mutation à une topologie de réseau simulé, on modifie l'un des paramètres qui définit le réseau parmi les branches, les longueurs de branches, les impédances caractéristiques des branches et les impédances des charges à l'extrémité des branches. La modification d'une branche du réseau correspond soit à la suppression d'une branche, soit à l'ajout d'une nouvelle branche connectée à une jonction.

Les réseaux modifiés obtenus en sortie de l'algorithme génétique 506 viennent remplacer 507 à la prochaine itération, les réseaux simulés de l'itération précédente et le procédé reboucle à l'étape 504.

On décrit à présent une autre variante de réalisation de l'invention, applicable à tous les modes de réalisation de l'invention décrits précédemment. Dans cette variante, on suppose que les extrémités du réseau dont on souhaite reconstruire la topologie sont connues et accessibles. Dans ce cas, les impédances des charges aux extrémités ne sont plus considérées dans les paramètres de topologie à rechercher.

Dans une étape préalable non représentée sur les figures 3 et 5, on effectue une première mesure de réflectométrie $R_{m,a}$ sur le réseau de câbles dont les extrémités sont connectées à des charges adaptées aux câbles. Pour un tel réseau, il n'y a pas de réflexion du signal sur les extrémités des câbles, ce qui permet de simplifier l'analyse du réflectogramme et de reconstruire directement les deux premières jonctions du réseau ainsi que les longueurs des branches entre ces deux jonctions.

Grâce à cette étape préalable, le nombre d'hypothèses de réseaux à simuler lors de la deuxième étape 302,502 du procédé est diminué.

Dans un second temps, le procédé est appliqué selon l'un des modes de réalisation décrits ci-dessus en effectuant une seconde mesure de réflectométrie $R_{m,o}$ sur le même réseau sans les charges adaptées aux extrémités du réseau, c'est-à-dire avec des extrémités en circuit ouvert.

Cette seconde mesure de réflectométrie est utilisée comme point d'entrée du procédé et correspond à la première étape 301,501.

Les différents modes de réalisation de l'invention décrits ont pour point commun l'utilisation d'un algorithme d'optimisation génétique qui a pour fonction de modifier les hypothèses de réseaux de câbles simulés de sorte à améliorer le critère d'erreur global de l'ensemble des hypothèses à chaque itération.

Le procédé selon l'invention peut être mis en oeuvre en tant que programme d'ordinateur, le procédé étant appliqué à une mesure de réflectométrie $R_m$ préalablement acquise à l'aide d'un dispositif de réflectométrie usuel. L'invention peut être mise en oeuvre en tant que programme d'ordinateur comportant des instructions pour son exécution. Le programme d'ordinateur peut être enregistré sur un support d'enregistrement lisible par un processeur. La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués *("Cloud computing"),* éventuellement selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

Alternativement, l'invention peut aussi être mise en oeuvre dans un dispositif embarqué du type de celui de la figure 1 comprenant en outre un calculateur configuré pour exécuter le procédé selon l'invention afin de fournir, à partir d'un réflectogramme mesuré $R_m$, une ou plusieurs topologies probables du réseau sous test. Le dispositif peut comporter également un moyen d'affichage des résultats du procédé sous forme de graphe ou sous forme numérique.

Références

[1] : « Algorithmes génétiques », Selvaraj Ramkumar, 26 avril 2007.
[2] : R. Fletcher, "Pratical methods of optimization", John Wiley & Sons, 2013.

**Revendications**

**1.** Procédé itératif, mis en oeuvre par ordinateur, de reconstruction de la topologie d'un réseau de câbles comprenant les étapes de :

- Obtenir (301,501) un réflectogramme temporel mesuré $R_m$ à partir d'un signal préalablement injecté dans le réseau de câbles,
- Simuler (302,502) initialement une pluralité d'hypothèses de réseaux de câbles ($H_{i,j}$) couvrant tous les paramètres structurels possibles de topologie de réseaux de câbles, les paramètres structurels comprenant au moins le nombre de jonctions et le nombre de branches reliées à chaque jonction, puis exécuter itérativement les étapes suivantes :

- Obtenir (303,503), pour chaque hypothèse de réseau de câbles simulé ($H_{i,j}$), un réflectogramme temporel simulé associé $R_{i,j}$,

- Evaluer (304,504), pour chaque hypothèse de réseau de câbles simulé ($H_{i,j}$), un critère d'erreur $E(R_{i,j}-R_m)$ entre le réflectogramme temporel mesuré $R_m$ et le réflectogramme temporel simulé $R_{i,j}$,

- Appliquer (307,506) auxdits réseaux de câbles simulés un algorithme d'optimisation génétique ayant pour fonction de produire une pluralité de réseaux de câbles modifiés présentant globalement un critère d'erreur $E(R_{i,j}-R_m)$ diminué,

- Remplacer (308,507) lesdits réseaux de câbles simulés de l'itération précédente par lesdits réseaux de câbles modifiés pour l'itération suivante.

2. Procédé itératif de reconstruction de la topologie d'un réseau de câbles selon la revendication 1 dans lequel l'algorithme d'optimisation génétique (303,503) comprend au moins une opération de mutation d'un réseau de câbles simulé pour obtenir un réseau de câbles modifié.

3. Procédé itératif de reconstruction de la topologie d'un réseau de câbles selon l'une des revendications précédentes dans lequel l'algorithme d'optimisation génétique (503) comprend au moins une opération de croisement de deux réseaux de câbles simulés pour obtenir un réseau de câble modifié, un croisement étant appliqué sur les paramètres structurels et les paramètres numériques de topologie d'un réseau de câble.

4. Procédé itératif de reconstruction de la topologie d'un réseau de câbles selon l'une des revendications précédentes dans lequel les P réseaux de câbles simulés qui présentent les critères d'erreur les plus faibles ne sont pas modifiés par l'algorithme d'optimisation génétique, P étant un nombre entier prédéterminé au moins égal à un.

5. Procédé itératif de reconstruction de la topologie d'un réseau de câbles selon l'une des revendications 1, 2 ou 4 dans lequel l'algorithme d'optimisation génétique (303) comprend au moins une opération de croisement de deux réseaux de câbles simulés pour obtenir un réseau de câbles modifié, un croisement étant appliqué uniquement sur les paramètres numériques de topologie d'un réseau de câble.

6. Procédé itératif de reconstruction de la topologie d'un réseau de câbles selon l'une quelconque des revendications précédentes comprenant en outre une étape de supprimer (305), avant d'appliquer l'algorithme d'optimisation, les M réseaux de câbles simulés qui présentent les critères d'erreur les plus élevés, M étant un nombre entier prédéterminé au moins égal à un.

7. Procédé itératif de reconstruction de la topologie d'un réseau de câbles selon l'une des revendications précédentes comprenant un test d'arrêt (306) comprenant une étape de comparer les critères d'erreur des réseaux de câbles simulés restants à un second seuil prédéterminé et si au moins un réseau de câble simulé présente un critère d'erreur inférieur audit second seuil arrêter le procédé.

8. Procédé itératif de reconstruction de la topologie d'un réseau de câbles selon l'une des revendications précédentes dans lequel le critère d'erreur est une distance euclidienne.

9. Procédé de reconstruction de la topologie d'un réseau de câbles selon l'une des revendications précédentes comprenant une étape d'affichage de la topologie reconstruite du réseau de câbles sur un dispositif d'affichage.

10. Procédé de reconstruction de la topologie d'un réseau de câbles selon l'une des revendications précédentes comprenant une étape préalable d'injection du signal dans le réseau de câbles.

11. Programme d'ordinateur comportant des instructions pour l'exécution du procédé de reconstruction de la topologie d'un réseau de câbles selon l'une quelconque des revendications 1 à 9, lorsque le programme est exécuté par un processeur.

12. Support d'enregistrement lisible par un processeur sur lequel est enregistré un programme comportant des instructions pour l'exécution du procédé de reconstruction de la topologie d'un réseau de câbles selon l'une quelconque des revendications 1 à 9, lorsque le programme est exécuté par un processeur.

**Patentansprüche**

1. Computer-implementiertes iteratives Verfahren zur Rekonstruktion der Topologie eines Kabelnetzwerkes, umfassend die folgenden Schritte:

- Erhalten (301, 501) eines gemessenen zeitlichen Reflektogramms $R_m$ anhand eines zuvor in das Kabelnetzwerk eingespeisten Signals,
- anfängliches Simulieren (302, 502) einer Vielzahl von Kabelnetzwerkhypothesen ($H_{i,j}$), die alle möglichen strukturellen Parameter der Kabelnetzwerktopologie abdecken, wobei die strukturellen Parameter mindestens die Anzahl von Verbindungsstellen und die Anzahl von mit jeder Verbindungsstelle verbundenen Abzweigungen umfassen,

dann iteratives Ausführen der folgenden Schritte:

- Erhalten (303, 503), für jede Hypothese des simulierten Kabelnetzwerkes ($H_{i,j}$), eines zugeordneten simulierten zeitlichen Reflektogramms $R_{i,j}$,
- Auswerten (304, 504), für jede Hypothese des simulierten Kabelnetzwerkes ($H_{i,j}$), eines Fehlerkriteriums $E(R_{i,j}-R_m)$ zwischen dem gemessenen zeitlichen Reflektogramm $R_m$ und dem simulierten zeitlichen Reflektogramm $R_{i,j}$,
- Anwenden (307, 506), auf die simulierten Kabelnetzwerke, eines genetischen Optimierungsalgorithmus, dessen Funktion das Erzeugen einer Vielzahl von modifizierten Kabelnetzwerken ist, die insgesamt ein reduziertes Fehlerkriterium $E(R_{i,j}-R_m)$ aufweisen,
- Ersetzen (308, 507) der simulierten Kabelnetzwerke der vorhergehenden Iteration durch die modifizierten Kabelnetzwerke für die folgende Iteration.

2. Iteratives Verfahren zur Rekonstruktion der Topologie eines Kabelnetzwerkes nach Anspruch 1, wobei der genetische Optimierungsalgorithmus (303, 503) mindestens eine Mutationsoperation eines simulierten Kabelnetzwerkes umfasst, um ein modifiziertes Kabelnetzwerk zu erhalten.

3. Iteratives Verfahren zur Rekonstruktion der Topologie eines Kabelnetzwerkes nach einem der vorhergehenden Ansprüche, wobei der genetische Optimierungsalgorithmus (503) mindestens eine Operation zum Kreuzen von zwei simulierten Kabelnetzwerken umfasst, um ein modifiziertes Kabelnetzwerk zu erhalten, wobei eine Kreuzung auf die strukturellen Parameter und die digitalen Parameter der Topologie eines Kabelnetzwerkes angewendet wird.

4. Iteratives Verfahren zur Rekonstruktion der Topologie eines Kabelnetzwerkes nach einem der vorhergehenden Ansprüche, wobei die P simulierten Kabelnetzwerke, die die schwächsten Fehlerkriterien aufweisen, nicht von dem genetischen Optimierungsalgorithmus modifiziert werden, wobei P eine vorbestimmte ganze Zahl mindestens gleich eins ist.

5. Iteratives Verfahren zur Rekonstruktion der Topologie eines Kabelnetzwerkes nach einem der Ansprüche 1, 2 oder 4, wobei der genetische Optimierungsalgorithmus (303) mindestens eine Operation zum Kreuzen von zwei simulierten Kabelnetzwerken umfasst, um ein modifiziertes Kabelnetzwerk zu erhalten, wobei eine Kreuzung nur auf die digitalen Parameter der Topologie eines Kabelnetzwerkes angewendet wird.

6. Iteratives Verfahren zur Rekonstruktion der Topologie eines Kabelnetzwerkes nach einem der vorhergehenden Ansprüche, ferner umfassend einen Schritt des Unterdrückens (305), vor dem Anwenden des Optimierungsalgorithmus, der M simulierten Kabelnetzwerke, die die höchsten Fehlerkriterien aufweisen, wobei M eine vorbestimmte ganze Zahl mindestens gleich eins ist.

7. Iteratives Verfahren zur Rekonstruktion der Topologie eines Kabelnetzwerkes nach einem der vorhergehenden Ansprüche, umfassend einen Haltetest (306), umfassend einen Schritt des Vergleichens der Fehlerkriterien der simulierten Kabelnetzwerke, die auf einem vorbestimmten zweiten Schwellenwert bleiben, und wenn mindestens ein simuliertes Kabelnetzwerk ein Fehlerkriterium aufweist, das kleiner als der zweite Schwellenwert ist, des Anhaltens des Verfahrens.

8. Iteratives Verfahren zur Rekonstruktion der Topologie eines Kabelnetzwerkes nach einem der vorhergehenden Ansprüche, wobei das Fehlerkriterium ein euklidischer Abstand ist.

9. Verfahren zur Rekonstruktion der Topologie eines Kabelnetzwerkes nach einem der vorhergehenden Ansprüche, umfassend einen Schritt des Anzeigens der rekonstruierten Topologie des Kabelnetzwerkes auf einer Anzeigevorrichtung.

**10.** Verfahren zur Rekonstruktion der Topologie eines Kabelnetzwerkes nach einem der vorhergehenden Ansprüche, umfassend einen vorausgehenden Schritt des Einspeisens des Signals in das Kabelnetzwerk.

**11.** Computerprogramm, umfassend Anweisungen zum Ausführen des Verfahrens zur Rekonstruktion der Topologie eines Kabelnetzwerkes nach einem der Ansprüche 1 bis 9, wenn das Programm von einem Prozessor ausgeführt wird.

**12.** Speichermedium, das von einem Prozessor lesbar ist, auf dem ein Programm gespeichert ist, das Anweisungen zum Ausführen des Verfahrens zur Rekonstruktion der Topologie eines Kabelnetzwerkes nach einem der Ansprüche 1 bis 9 umfasst, wenn das Programm von einem Prozessor ausgeführt wird.

**Claims**

**1.** A computer-implemented iterative method for reconstructing the topology of a cable network, comprising the steps of:

- obtaining (301, 501) a measured time reflectogram $R_m$ from a signal previously injected into the cable network,
- initially simulating (302, 502) a plurality of cable network hypotheses ($H_{i,j}$) covering all the possible cable network structural topology parameters, the structural parameters comprising at least the number of junctions and the number of branches connected to each junction,

then iteratively executing the following steps:

- obtaining (303, 503), for each simulated cable network hypothesis ($H_{i,j}$), an associated simulated time reflectogram $R_{i,j}$,
- evaluating (304, 504), for each simulated cable network hypothesis (Hij), an error criterion $E(R_{i,j}-R_m)$ between the measured time reflectogram $R_m$ and the simulated time reflectogram $R_{i,j}$,
- applying (307, 506), to said simulated cable networks, a genetic optimization algorithm having the function of producing a plurality of modified cable networks having, overall, a reduced error criterion $E(R_{i,j}-R_m)$,
- replacing (308, 507) said simulated cable networks from the previous iteration with said modified cable networks for the following iteration.

**2.** The iterative method for reconstructing the topology of a cable network according to claim 1, wherein the genetic optimization algorithm (303, 503) comprises at least one operation of mutating a simulated cable network in order to obtain a modified cable network.

**3.** The iterative method for reconstructing the topology of a cable network according to one of the preceding claims, wherein the genetic optimization algorithm (503) comprises at least one operation of crossing over two simulated cable networks in order to obtain a modified cable network, a crossover being applied to the structural topology parameters and the numerical topology parameters of a cable network.

**4.** The iterative method for reconstructing the topology of a cable network according to one of the preceding claims, wherein the P simulated cable networks that have the lowest error criteria are not modified by the genetic optimization algorithm, P being a predetermined integer at least equal to one.

**5.** The iterative method for reconstructing the topology of a cable network according to one of claims 1, 2 or 4, wherein the genetic optimization algorithm (303) comprises at least one operation of crossing over two simulated cable networks in order to obtain a modified cable network, a crossover being applied only to the numerical topology parameters of a cable network.

**6.** The iterative method for reconstructing the topology of a cable network according to one of the preceding claims, further comprising a step of eliminating (305) the M simulated cable networks that have the highest error criteria before applying the optimization algorithm, M being a predetermined integer at least equal to one.

**7.** The iterative method for reconstructing the topology of a cable network according to one of the preceding claims, comprising a stop test (306) comprising a step of comparing the error criteria of the remaining simulated cable networks with a predetermined second threshold and, if at least one simulated cable network has an error criterion lower than said second threshold, stopping the method.

8. The iterative method for reconstructing the topology of a cable network according to one of the preceding claims, wherein the error criterion is a Euclidean distance.

9. The method for reconstructing the topology of a cable network according to one of the preceding claims, comprising a step of displaying the reconstructed topology of the cable network on a display device.

10. The method for reconstructing the topology of a cable network according to one of the preceding claims, comprising a preliminary step of injecting the signal into the cable network.

11. A computer program comprising instructions for executing the method for reconstructing the topology of a cable network according to any one of claims 1 to 9 when the program is executed by a processor.

12. A recording medium able to be read by a processor and on which there is recorded a program comprising instructions for executing the method for reconstructing the topology of a cable network according to any one of claims 1 to 9 when the program is executed by a processor.

FIG.1

R(n)

(n)

N

N+M

FIG.1bis

FIG.2a

FIG.2b

EP 3 665 490 B1

FIG.3

FIG.4a

FIG.4b

FIG.5

FIG.6a

FIG.6b

FIG.6c

## RÉFÉRENCES CITÉES DANS LA DESCRIPTION

**Documents brevets cités dans la description**

- US 20060182269 A

**Littérature non-brevet citée dans la description**

- **SELVARAJ RAMKUMAR.** Algorithmes génétiques. 26 Avril 2007

- **R. FLETCHER.** Pratical methods of optimization. John Wiley & Sons, 2013